# FASCICULE DE BREVET EUROPEEN

(11) **EP 3 523 828 B1**
(45) Date de publication et mention de la délivrance du brevet: **12.08.2020**
(21) Numéro de dépôt: 17780381.4
(22) Date de dépôt: 04.10.2017
(51) Int. Cl.: H01L 31/0224, H01L 31/068, H01L 31/18

(54) **CONTACTS PERFECTIONNÉS D'UNE CELLULE PHOTOVOLTAÏQUE À DEUX FACES ACTIVES**
VERBESSERTE KONTAKTE FÜR EINE FOTOVOLTAISCHE ZELLE MIT ZWEI AKTIVEN FLÄCHEN
IMPROVED CONTACTS FOR A PHOTOVOLTAIC CELL HAVING TWO ACTIVE FACES

(30) Priorité: 05.10.2016 FR 1659624
(43) Date de publication de la demande: 14.08.2019
(73) Titulaire: Electricité de France, 75008 Paris (FR); Centre National de la Recherche Scientifique CNRS, 75016 Paris (FR); Paris Sciences et Lettres - Quartier Latin, 75006 Paris (FR)
(72) Inventeur: GRAND, Pierre-Philippe, 83470 Saint-Maximin La Sainte Baume (FR); LINCOT, Daniel, 92160 Antony (FR)
(74) Mandataire: Plasseraud IP
(86) Numéro de dépôt international: PCT/EP2017/075242
(87) Numéro de publication internationale: WO 2018/065478

(56) Documents cités:
- CN-A- 105 590 987
- US-A1- 2012 132 264
- US-A1- 2014 109 967
- US-A1- 2014 251 817
- US-A1- 2016 005 903

## Description

L'invention se situe dans le domaine de la fabrication de cellules photovoltaïques, et est plus particulièrement relative au dépôt de contacts sur de telles cellules.

Dans le cas par exemple où de telles cellules sont à base de silicium, les cellules dominant actuellement le marché photovoltaïque sont mono-faciales (une seule face active recevant les rayons lumineux), la face arrière étant entièrement métallisée. Néanmoins, dans un but d'augmentation des rendements de conversion photovoltaïques, le développement de cellules dites « bifaciales » connait actuellement un grand essor. En effet, dans ces structures à deux faces actives opposées, l'efficacité du panneau est la somme du rendement obtenu sur la face avant (rayonnement direct) et de celui obtenu sur la face arrière (qui ne reçoit que le rayonnement réfléchi - environ 20% de la lumière incidente sur du gazon par exemple). L'ordre de grandeur de gain de conversion par rapport à une cellule mono-faciale est donc d'environ 3 à 4% absolu, en fonction du taux de réflexion de la surface incidente (gazon, neige, sable, etc.). Néanmoins, le développement de cellules bifaciales est freiné du fait du coût élevé de leur production ainsi que des limitations de performances liées notamment à l'utilisation de la sérigraphie à base de pâte d'argent pour la métallisation de contacts métalliques.

Une alternative à la métallisation par sérigraphie est l'utilisation de placage électrochimique, qui commence à être industrialisé pour les cellules mono-faciales. L'intérêt général du placage électrochimique par rapport à la sérigraphie est :
- d'un point de vue performance :
   - diminuer le taux d'ombrage de la cellule par diminution de la taille du motif métallisé (largeur des doigts de collectes pouvant être réduit de plus de 50%),
   - permettre le contactage d'émetteurs très résistifs (>120Ω),
   - améliorer la conductivité électrique et diminuer la résistance de contact avec l'émetteur,
- d'un point de vue économique :
   - supprimer (ou diminuer très fortement) la quantité d'Argent et le remplacer par le Cuivre (avec un gain de facteur 100 sur le coût du métal),
   - remplacer la sérigraphie par une méthode électrochimique (présentant un meilleur taux d'utilisation de matière première).

Le placage électrochimique n'étant pas possible par électrolyse conventionnelle (du fait de la trop grande résistivité du silicium), l'approche la plus communément utilisée est une approche dite « mixte » d'épaississement de contacts sérigraphiés.

On peut stimuler aussi certaines propriétés du substrat en silicium et deux techniques électrochimiques courantes pour le placage direct sur un substrat de Silicium sont :
- le dépôt induit par la lumière (dit « Light Induced Plating » ou LIP), et
- le dépôt dans le sens de polarisation de la diode (dit « Forward Bias Plating » ou FBP).

Le dépôt induit par la lumière (LIP) est utilisé pour la métallisation de la face n⁺. Dans ce cas, en éclairant le semi-conducteur, la jonction p-n génère des paires électrons-trous. Par application d'un potentiel entre une anode à la face arrière (p⁺) de la cellule photovoltaïque préalablement métallisée, les électrons générés sont utilisés sur la face n⁺ pour réduire les sels métalliques présents dans le bain de dépôt.

Or, la « compétition » sur la face p⁺ entre la formation de trous (lié à la photo-génération du courant) et l'arrivée d'électrons pour alimenter la réaction de réduction sur la face n⁺ est incompatible avec la formation d'un composé par électrolyse sur une cellule bifaciale. Ainsi, dans une technique de type LIP, la face arrière de la cellule est souvent hors bain d'électrolyse pour prévenir les problèmes de corrosion ou de sur-dépôt.

La technique de dépôt dans le sens de polarisation de la diode (FBP) est utilisée pour la métallisation de la face p⁺. Dans ce cas, par connexion à une anode à la face arrière de la cellule solaire (n⁺), un potentiel ou courant cathodique est appliqué sur la face arrière préalablement métallisée. Ce potentiel sert à générer des électrons qui traversent la diode et sont disponibles sur la face p⁺. Toutefois, là encore cette technique n'est pas utilisable pour une cellule bifaciale car si les deux faces sont exposées au bain d'électrolyse, l'application du potentiel (ou du courant) conduit à la formation d'un composé par réduction sur la face n⁺. La formation de ce composé conducteur « bloque » alors la circulation des électrons à travers la diode et seul un dépôt sur la face n⁺ est obtenu.

Bien entendu, on peut prévoir une combinaison des deux techniques (LIP et FBP) pour réaliser la métallisation de cellules bifaciales mais cette combinaison nécessite une mise en œuvre lourde et complexe (métallisation obligatoirement séquentielle, gestion de la prise de contact électrique et des lignes de champs entre les deux faces, besoin d'un alignement précis entre les ouvertures des deux faces). Le document US 2014/0251817 A1 décrit un procédé de fabrication de contact métallique selon l'état de l'art.

La seule technique de métallisation (éléctro)chimique permettant de déposer simultanément un métal sur les deux faces du Silicium (une de type p⁺ et l'autre de type n⁺) est une méthode dite autocatalytique « electroless ». Elle présente néanmoins des inconvénients : complexité de mise en œuvre, nécessité d'activation de la surface préalablement au dépôt (souvent à l'aide d'un bain contenant du palladium, métal onéreux), temps de dépôt long (≈0,1 µm/minute), durée de vie du bain courte et gestion du bain délicate, et ce à une température de dépôt élevée (supérieure à 80°C). Par ailleurs, la vitesse de dépôt dépend du type de surface à couvrir (avec une sélectivité différente sur les faces de la cellule).

Il est souhaité alors un dépôt électrochimique simultané des contacts de la face avant et arrière de la cellule bifaciale qui soit plus adaptée, en termes de facilité de mise en œuvre, de vitesse de dépôt, etc.

La présente invention vient améliorer cette situation.

Elle propose à cet effet un procédé de fabrication d'une cellule photovoltaïque bifaciale, à deux faces actives opposées, comportant une étape de dépôt, sur chaque face active, d'au moins un contact électrique. L'étape de dépôt comporte en particulier une opération commune de dépôt sur chacune des faces actives, mise en œuvre par électrolyse dans une cuve commune d'électrolyse comportant :
- un premier compartiment pour le dépôt d'une couche métallique sur une première face active de la cellule, pour la fabrication d'un contact comportant ladite couche métallique sur la première face active, et
- un deuxième compartiment pour le dépôt, par oxydation, d'une couche d'oxyde métallique conducteur, sur la deuxième face active de la cellule, pour la fabrication d'un contact comportant ladite couche d'oxyde métallique sur la deuxième face active.

Le métal de la couche d'oxyde métallique est au moins un élément parmi Mn, Ni, Mo, Cd, Sn, In, Zn, Pb, Ag, Cu, In, Ga, Co, W, Ta, Ga et Ti.

Plus particulièrement, pendant l'opération commune de dépôt :
- des électrons sont générés dans le premier compartiment, en regard de la première face active, pour favoriser le dépôt de la couche métallique, et
- des trous sont générés dans le deuxième compartiment, en regard de la deuxième face active, pour favoriser le dépôt par oxydation de la couche d'oxyde métallique.

Dans une réalisation, les premier et deuxième compartiments sont séparés par une membrane échangeuse d'ions que comporte la cuve d'électrolyse.

Préférentiellement, le dépôt:
- de la couche métallique sur la première face active, et
- de la couche d'oxyde métallique sur la deuxième face active,
   est assisté par éclairage de l'une au moins des première et deuxième faces actives.

En effet, l'éclairage favorise la génération des paires électrons/trous et donc le dépôt simultané de la couche métallique et de la couche d'oxyde métallique. Cet éclairage peut donc être réalisé sur au moins l'une quelconque des deux faces.

Optionnellement, l'opération de dépôt est assistée par application d'une différence de potentiel propre à générer au moins des charges négatives sur la première face active. Alternativement ou en complément, l'opération de dépôt peut être assistée par application d'une différence de potentiel propre à générer des charges positives sur la deuxième face active.

Dans une réalisation, la cellule photovoltaïque est bifaciale à homo-jonction, de type n+ sur la première face active et p+ sur la deuxième face active.

Le matériau massique (ou « bulk », appelé encore substrat SUB ci-après) peut être par exemple du Silicium, de type n ou p. Les surfaces du matériau restent toutefois:
- de type p⁺ sur une face,
- et de type n⁺ sur l'autre face, opposée.

Comme indiqué à titre d'exemple plus haut, la cellule photovoltaïque peut être à base de silicium.

Dans une réalisation possible, la couche métallique sur la première face active peut être à base de nickel, et l'étape de dépôt de contact électrique sur cette première face active peut se poursuivre ensuite par le dépôt sur la couche métallique d'une couche comportant au moins du cuivre, par électrolyse. Cette solution est très avantageuse économiquement car elle vient remplacer le dépôt d'une pâte d'argent, onéreuse, habituellement réalisé par sérigraphie.

L'étape de dépôt de contact électrique sur la deuxième face active peut se poursuivre aussi par le dépôt sur la couche d'oxyde métallique d'une couche comportant au moins du cuivre, par électrolyse (dès lors que l'oxyde est conducteur).

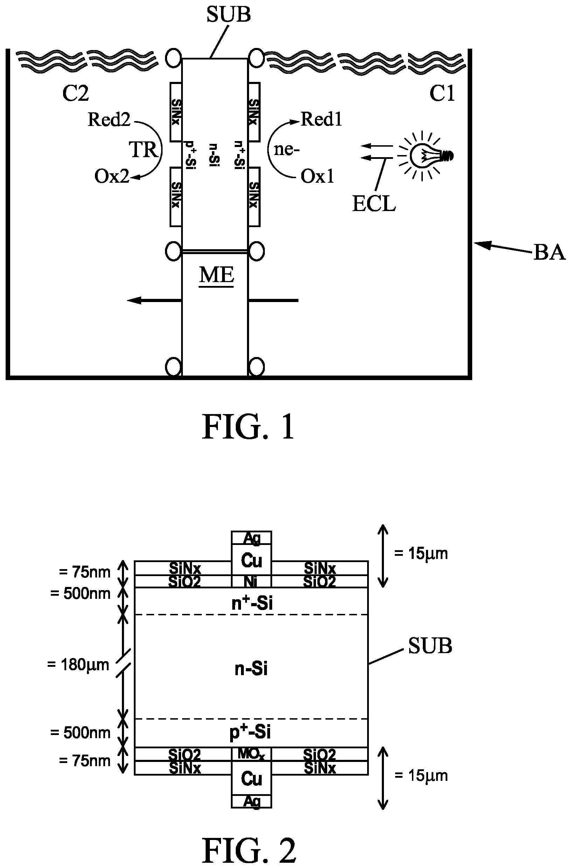

Comme on le verra en référence à la figure 1 commentée en détails plus loin, l'étape de dépôt de contact est précédée par une étape de gravure d'au moins une couche électriquement isolante (SiO₂, SiNₓ), déposée sur chaque face active. Cette gravure met à nu chaque face active dans une région dans laquelle peut être ensuite appliquée l'opération précitée de dépôt simultané par électrolyse.

La présente invention vise aussi une cellule photovoltaïque bifaciale, à deux faces actives opposées, la cellule comportant sur chaque face active au moins un contact électrique. En particulier, le contact d'une première face active comporte une couche métallique déposée sur la première face active, tandis que le contact de la deuxième face active comporte une couche d'oxyde métallique conducteur déposée sur la deuxième face active.

La différence du matériau de contact entre les deux faces, avec en particulier :
- l'un en métal, et
- l'autre en oxyde de métal conducteur,
   marque une trace du procédé sur la cellule obtenue par la mise en œuvre de ce procédé de l'invention et ainsi, une telle cellule peut être obtenue par la mise en œuvre du procédé ci-avant.

Comme indiqué ci-avant, la cellule peut être du type homo-jonction, de type n⁺ sur la première face active et p⁺ sur la deuxième face active.

D'autres avantages et caractéristiques de l'invention apparaitront à la lecture de la description détaillée ci-après d'exemples de réalisation de l'invention, et à l'examen des dessins annexés sur lesquels :
- la figure 1 présente une réalisation pour la fabrication par électrolyse d'une cellule au sens de l'invention,
- la figure 2 présente un exemple d'une cellule au sens de l'invention,
- les figures 3 à 5 présentent des réalisations alternatives à celle de la figure 1, pour la fabrication par électrolyse d'une cellule au sens de l'invention,

Dans l'exemple de réalisation exposé ci-après, il est proposé d'utiliser la propriété semiconductrice de la jonction P-N de la cellule photovoltaïque bifaciale : l'éclairement d'au moins l'une des deux faces conduit à la photo-génération de paires électrons/trous. Des électrons sont générés sur la face n⁺ et des « trous » sur la face p⁺. Il est donc possible d'effectuer une réaction électrochimique de réduction sur la face n⁺ (donc de déposer un métal), et en parallèle, de favoriser une réaction électrochimique d'oxydation sur la face opposée p⁺ (donc de déposer un oxyde métallique typiquement).

Ainsi, sans connexion nécessaire à un circuit extérieur, si le matériau photovoltaïque de la cellule (par exemple du silicium) est en contact avec deux électrolytes adéquats (un par face), il est donc possible de réaliser un dépôt simultané :
- sur la face dopée n⁺ : l'électro-dépôt d'un métal (par exemple du Nickel),
- sur la face dopée p⁺ : l'électro-dépôt d'un oxyde métallique (par exemple MnO₂, NiO, MoO₃, CdO, SnO₂, etc.).

Ainsi, en référence à la figure 1, le substrat SUB (par exemple de Silicium), à propriétés photovoltaïques et comportant des première et deuxième faces actives opposées (dopées n+ et p+ respectivement) est plongé dans une cuve d'électrolyse BA. Une membrane ME échangeuse d'ions (anionique ou cationique) est prévue en outre dans le prolongement du substrat SUB pour fermer deux compartiments respectifs C1 et C2 dans la cuve.

L'éclairement ECL de l'une au moins des faces favorise la photo-génération d'électrons ne- sur la première face (dans le compartiment C1) et de trous TR sur la deuxième face (dans le compartiment C2). Les électrons dans le compartiment C1 permettent le dépôt du métal (par exemple du Nickel Ni) sur la surface libre du substrat (entre les deux masques de nitrure de silicium SiNₓ). Parallèlement et simultanément en particulier, dans le compartiment C2, il se crée des « trous » (charges positives) favorisant le dépôt d'oxyde métallique, et notamment le dépôt d'un oxyde conducteur (par exemple MnO₂ ou autre comme présenté dans les exemples plus loin).

En particulier, l'oxyde métallique déposé par électrochimie sur la face p⁺ a de préférence les propriétés suivantes. Il s'agit d'un :
- conducteur électrique équivalent en ordre de grandeur au Nickel (14.10⁶ S/m)
- formant un contact ohmique avec le Silicium
- et barrière à la diffusion du Cuivre dans le Silicium
- sans se dégrader sous traitement thermique (gamme 350-550°C) pour les étapes ultérieures de fabrication de la cellule,
- tout en minimisant le taux d'impuretés (par exemple du carbone) dans la couche résultante.

De plus, si cet oxyde est transparent et conducteur (comme l'oxyde de titane ou ITO), il peut permettre la collecte électrique et ce en laissant passer la lumière incidente (taux d'ombrage réduit).

De façon préférentielle, sur cet oxyde, on peut avantageusement déposer du cuivre par électrolyse pour augmenter la conductivité des contacts électriques. Ensuite, une fine couche d'argent peut être déposée sur le cuivre pour le protéger de l'oxydation et améliorer sa soudabilité en vue de fabriquer des modules photovoltaïques assemblés. Enfin, un traitement thermique peut être réalisé pour permettre sur la face n⁺ de former du NiSi, qui a un rôle de contact ohmique sur le silicium et de prévention de la diffusion du Cuivre.

Ainsi, la cellule solaire peut présenter un empilement du type illustré sur la figure 2 (dans un exemple de réalisation relatif à une cellule bifaciale ici de type N-PERT, pour « Passivated Emitter, Rear Totally Diffused »), sur laquelle :
- la référence MOₓ désigne de manière générale un oxyde métallique avec M préférentiellement mais non limitativement au moins l'un des éléments : Mn, Cr, Fe, Co, Ni, Cu, Zn, Cd, W, Mo, In, Ga, Ta, V. Les métaux nobles (Pd, Pt, Au, Ag) peuvent être également être envisagés avec toutefois un coût de fabrication plus élevé ;
- la référence SiNₓ désigne du ou des nitrures de silicium (et SiO₂ de la silice).

Utiliser une technique électrochimique pour la formation des contacts électrique présente de nombreux avantages (par rapport à la technique habituelle qui est la sérigraphie) :
- réduction du coût de fabrication (notamment par réduction de la quantité d'Argent à déposer), et
- augmentation des performances (contactage d'émetteurs très résistifs, amélioration du taux d'ombrage, meilleure conductivité).

En outre, l'utilisation de l'éclairement d'un substrat photovoltaïque pour déposer par voie humide sur les deux faces, simultanément et sans contact à un circuit extérieur, des couches à base de métaux (dont un oxyde) présente aussi des avantages :
- il permet d'utiliser le photo-courant généré par la diode pour électro-déposer le métal et l'oxyde métallique.
- la connexion à un circuit extérieur n'est pas nécessaire car le couple d'oxydo-réduction sur chacune des deux faces est directement à l'interface substrat photovoltaïque/électrolyte.

Plus précisément, en référence à nouveau à la figure 1, les phénomènes mis en œuvre sont :
- la photo-génération d'électrons sur la face n⁺ en contact avec un composé réductible dans le compartiment C1, avec une réaction du type : Ox₁ + ne⁻ → Red₁
- la photo-génération de « trous » sur la face p+ en contact avec un composé oxydable dans le compartiment C2, avec une réaction du type : Red₂ → Ox₂ + ne⁻

Pour éviter l'acidification ou l'alcalinisation de l'un des compartiments, une membrane échangeuse d'ions (de type Nafion, anionique ou cationique) peut séparer les deux compartiments et maintenir l'équilibre ionique.

Le dispositif d'éclairement peut comporter une rangée de diodes ou de lampes halogènes présentant un maximum d'irradiation électromagnétique dans la région visible rouge à infrarouge proche. L'irradiation peut inclure préférablement le domaine des longueurs d'onde optiques ultraviolettes pour activer et/ou catalyser l'interface électrolyte/Silicium en vue de favoriser la nucléation des premiers germes de dépôt à la surface du silicium.

En fonction des réactions électrochimiques mises en jeu, l'éclairement peut avantageusement être appliqué sur les deux faces, permettant d'ajuster si besoin les potentiels électrochimiques sur les deux faces.

Le courant photo-généré (d'un ordre de grandeur de quelques dizaines de mA.cm⁻²), permet d'atteindre des vitesses de dépôts au moins 10 fois supérieures à celles obtenues par un procédé de type autocatalytique (procédé « electroless », le plus performant connu actuellement). L'étape d'activation du procédé electroless (démarrage de la nucléation du contact de Nickel Ni par exemple à l'aide de particules de Palladium) n'est pas nécessaire. Les bains électrolytiques mis en œuvres sont plus simples et stables que les bains electroless et permettent de réaliser des dépôts plus purs (moins d'impuretés de type carbone dans le film résultant). Le procédé global est donc plus rapide et moins onéreux que le procédé electroless, à performances photovoltaïques équivalentes.

Plus généralement, la mise en œuvre au sens de la présente invention présente de nombreux avantages par rapport aux techniques connues, telles que la technique par sérigraphie, Electroless et couple LIP/FBP. Déjà, le traitement de l'invention est simultané, rapide et sans contact électrique des deux faces des cellules solaires bifaciales pour la formation de grilles de collecte électrique en utilisant préférentiellement l'éclairement d'une des deux faces.

Plus particulièrement, relativement à la méthode electroless, la technique de l'invention permet :
- l'incorporation de moins d'impuretés (telles que le carbone, ou le phosphore) dans les dépôts ;
- un gain de temps de fabrication par le traitement simultané des deux faces et une vitesse de dépôt élevée,
- une gestion du bain plus facile en termes de durée de vie du bain, de recharge, de température de dépôt.

Relativement à la méthode par sérigraphie, l'invention apporte notamment une amélioration des performances des dispositifs photovoltaïques avec :
- une diminution du taux d'ombrage de la cellule par diminution de la taille du motif métallisé (largeur des doigts de collectes pouvant être réduit de plus de 50%),
- une amélioration du contactage d'émetteurs très résistifs (>120Ω),
- une amélioration de la conductivité électrique et une diminution de la résistance de contact avec l'émetteur.
ainsi qu'une économie de fabrication par :
- suppression (ou forte diminution) de l'Argent en le remplaçant par du Cuivre,
- remplacement de la sérigraphie par une méthode électrochimique (moins onéreuse).

On présente ci-après quelques exemples de réalisation particuliers.

Dans un premier exemple de réalisation présenté ci-après, il est procédé aux dépôts simultanés de MnO₂ sur la face p⁺ et de Nickel sur la face n⁺.

Dans une cuve à deux compartiments séparés par une membrane Nation échangeuses de cations, à l'aide d'un système de joints garantissant l'étanchéité des deux faces, un bain de métallisation de nickel est placé dans le compartiment n⁺ (C1) et un bain de métallisation de MnO₂ dans le compartiment p⁺ (C2). Le substrat (de Silicium) est éclairé avec une rangée de lampes LED blanches sur une face.

Pour le dépôt de Ni, dans un bain de Watts, une température de 60°C est appliquée pendant 2 minutes. Le nickel se dépose selon la réaction générale suivante :

Ni²⁺ + 2e⁻ → Ni

2H⁺ + 2e⁻ → H₂

Parallèlement, pour le dépôt de MnO₂ , dans un bain incluant 0,01 M de Mn(C₂H₃O₂)₂ (dit « Mn acetate »), 0,02 M de NH₄(C₂H₃O₂) (dit «ammonium acetate ») et 10% C₂H₆OS (dimethyl sulfoxide (DMSO)), on applique une température de 60°C pendant deux minutes. L'oxyde de manganèse se dépose alors anodiquement selon la réaction générale suivante :

Mn²⁺ + 2H₂O → MnO₂ + 4H⁺ + 2e⁻

La membrane échangeuse d'ions permet avantageusement d'équilibrer les protons (H⁺) entre les deux compartiments.

Sur les deux faces en simultané, on peut ensuite déposer du cuivre par électrolyse directe pour augmenter la conductivité des contacts électriques. Ensuite, une fine couche d'argent peut être déposée sur le cuivre pour le protéger de l'oxydation et améliorer sa soudabilité en vue de fabriquer des modules photovoltaïques. Enfin, un traitement thermique (gamme 350 - 550 °C) peut être réalisé pour permettre de former de l'alliage NiSi sur la face n⁺, qui a un rôle de contact ohmique sur le Silicium et de prévention de la diffusion du Cuivre.

Dans un deuxième mode de réalisation, de l'oxyde de Cadmium CdO est déposé sur la face p⁺ et du nickel est déposé sur la face n⁺.
Le dépôt de CdO peut être opéré à température ambiante dans 0,05M de cadmium acetate [Cd(C₂H₃O₂)₂] et 0,1M de Na₂SO₄.
Le même mode opératoire que celui décrit dans le premier mode de réalisation peut être appliqué ensuite (Nickelage sur la face n⁺, Cuivrage simultané sur les deux faces, Argentage puis traitement thermique).

Dans un troisième mode de réalisation, de l'oxyde d'étain SnO₂ est déposé sur la face p⁺ et du nickel sur la face n⁺, en prévoyant dans le DMSO, 0,1 M de SnCl₂ et 0,5 M de NaNO₃.

Dans un quatrième mode de réalisation, de l'oxyde de Manganèse MnO₂ est déposé sur la face p⁺ et du nickel sur la face n⁺ avec un bain unique de dépôt car dans ce cas, les deux faces du substrat sont exposées au même électrolyte qui contient au moins un sel de Nickel (par exemple un sulfate) et un sel de Manganèse Mn (par exemple un acétate). Par application de potentiels standards des réactions électrochimiques, la réaction de réduction du sel de Nickel a lieu à la cathode et la formation de l'oxyde de manganèse à l'anode. Dans le cas d'un bain unique, la membrane échangeuse d'ions n'est plus nécessaire (équilibre ionique établi par l'échange de protons entre les réactions à l'anode et à la cathode).

Bien entendu, la présente invention ne se limite pas aux formes de réalisation présentées ci-avant à titre d'exemples ; elle s'étend à d'autres variantes.

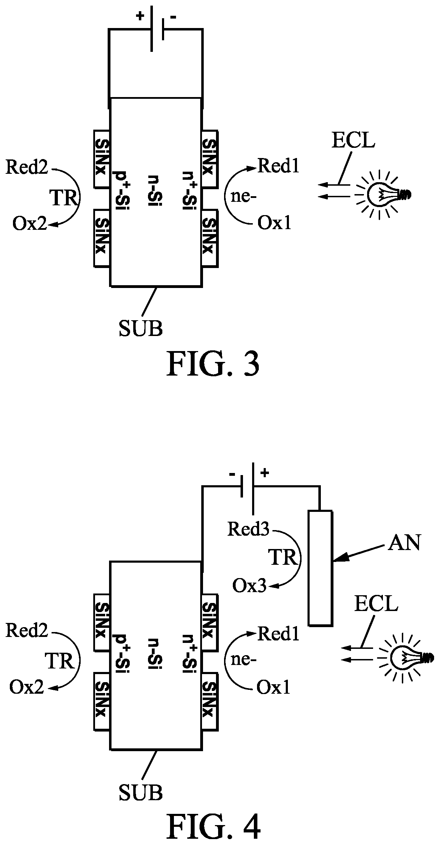

Le principe de photo-génération du courant par exemple admet des variantes de réalisation. Typiquement, il peut être assisté en outre par application d'un potentiel entre les bornes p⁺ et n⁺ du substrat (gamme préférentielle de 0 à 2V). Le sens de polarisation est présenté sur la figure 3.

Alternativement encore, par rapport à cette réalisation, il est possible de prévoir une électrode spécifique pour la réaction et différente du substrat. Le principe de photo-génération du courant reste le même mais il est assisté par application d'un potentiel entre la borne n⁺ du substrat et une anode (gamme préférentielle de 0 à 2V). Le sens de polarisation est décrit sur la figure 4. L'anode peut être soluble (par exemple en nickel, avantageusement) ou insoluble (par exemple en oxyde TiO₂/IrO₂).

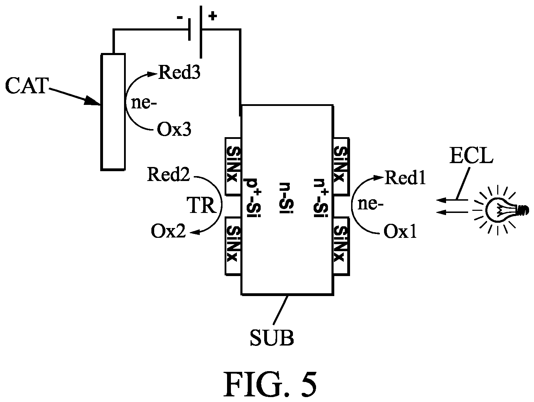

Alternativement encore, le sens de polarisation peut être tel que décrit sur la figure 5. Dans ce cas, la cathode est préférentiellement insoluble (par exemple en oxyde TiO₂/IrO₂).

Par ailleurs, on a décrit ci-avant l'usage d'un éclairement pour favoriser les réactions dans les deux compartiments de la cuve d'électrolyse. Cette réalisation est avantageuse dans le cas d'un substrat silicium notamment. Néanmoins, elle n'est pas forcément nécessaire par exemple pour un substrat autre que silicium. Typiquement, dans certains cas de substrat, la stimulation électrique présentée dans l'une des figures 3 à 5 pourrait suffire par exemple.

## Revendications

1. Procédé de fabrication d'une cellule photovoltaïque bifaciale, à deux faces actives opposées, comportant une étape de dépôt, sur chaque face active, d'au moins un contact électrique, **caractérisé en ce que** l'étape de dépôt comporte une opération commune de dépôt sur chacune des faces actives, mise en œuvre par électrolyse dans une cuve commune d'électrolyse comportant :
- un premier compartiment pour le dépôt d'une couche métallique sur une première face active de la cellule, pour la fabrication d'un contact comportant ladite couche métallique sur la première face active, et
- un deuxième compartiment pour le dépôt, par oxydation, d'une couche d'oxyde métallique conducteur, sur la deuxième face active de la cellule, pour la fabrication d'un contact comportant ladite couche d'oxyde métallique sur la deuxième face active,
et **en ce que** le métal de la couche d'oxyde métallique est au moins un élément parmi Mn, Ni, Mo, Cd, Sn, In, Zn, Pb, Ag, Cu, W, Ta, Ga, Fe, Co, Cr et Ti.

2. Procédé selon la revendication 1, **caractérisé en ce que**, pendant l'opération commune de dépôt :
- des électrons sont générés dans le premier compartiment, en regard de la première face active, pour favoriser le dépôt de la couche métallique, et
- des trous sont générés dans le deuxième compartiment, en regard de la deuxième face active, pour favoriser le dépôt par oxydation de la couche d'oxyde métallique.

3. Procédé selon l'une des revendications précédentes, **caractérisé en ce que** les premier et deuxième compartiments sont séparés par une membrane échangeuse d'ions que comporte la cuve d'électrolyse.

4. Procédé selon l'une des revendications précédentes, **caractérisé en ce que** le dépôt :
- de la couche métallique sur la première face active, et
- de la couche d'oxyde métallique sur la deuxième face active,
est assisté par éclairage de l'une au moins des première et deuxième faces actives.

5. Procédé selon l'une des revendications précédentes, **caractérisé en ce que** l'opération de dépôt est assistée par application d'une différence de potentiel propre à générer des charges négatives sur la première face active.

6. Procédé selon l'une des revendications précédentes, **caractérisé en ce que** l'opération de dépôt est assistée par application d'une différence de potentiel propre à générer des charges positives sur la deuxième face active.

7. Procédé selon l'une des revendications précédentes, **caractérisé en ce que** la cellule photovoltaïque est bifaciale à homo-jonction, de type n⁺ sur la première face active et p⁺ sur la deuxième face active.

8. Procédé selon l'une des revendications précédentes, **caractérisé en ce que** la cellule photovoltaïque est à base de silicium.

9. Procédé selon l'une des revendications précédentes, **caractérisé en ce que** la couche métallique sur la première face active est à base de nickel, et **en ce que** l'étape de dépôt de contact électrique sur la première face active se poursuit par le dépôt sur la couche métallique d'une couche comportant au moins du cuivre, par électrolyse.

10. Procédé selon l'une des revendications précédentes, **caractérisé en ce que** l'étape de dépôt de contact électrique sur la deuxième face active se poursuit par le dépôt sur la couche d'oxyde métallique d'une couche comportant au moins du cuivre, par électrolyse.

11. Procédé selon l'une des revendications précédentes, **caractérisé en ce que** l'étape de dépôt de contact est précédée par une étape de gravure d'au moins une couche électriquement isolante (SiO₂, SiNₓ), déposée sur chaque face active, ladite gravure mettant à nu chaque face active dans une région dans laquelle est appliquée l'opération de dépôt par électrolyse.

12. Cellule photovoltaïque bifaciale, obtenue par la mise en œuvre du procédé selon l'une des revendications précédentes, la cellule comportant deux faces actives opposées, et sur chaque face active au moins un contact électrique, **caractérisée en ce que** le contact d'une première face active comporte une couche métallique déposée sur la première face active, et **en ce que** le contact de la deuxième face active comporte une couche d'oxyde métallique conducteur déposée sur la deuxième face active.

13. Cellule selon la revendication 12, **caractérisée en ce qu'**elle comporte une homo-jonction, de type n⁺ sur la première face active et p⁺ sur la deuxième face active.

## Patentansprüche

1. Verfahren zur Herstellung einer bifazialen Photovoltaikzelle mit zwei entgegengesetzten aktiven Seiten, das einen Schritt des Abscheidens mindestens eines elektrischen Kontaktes auf jeder aktiven Seite umfasst, **dadurch gekennzeichnet, dass** der Schritt des Abscheidens einen gemeinsamen Abscheidevorgang auf jeder der aktiven Seiten umfasst, der durch Elektrolyse in einem gemeinsamen Elektrolysebehälter durchgeführt wird, der umfasst:
- eine erste Kammer zum Abscheiden einer Metallschicht auf einer ersten aktiven Seite der Zelle zur Herstellung eines Kontaktes, der die Metallschicht auf der ersten aktiven Seite umfasst, und
- eine zweite Kammer zum Abscheiden, durch Oxidation, einer leitfähigen Metalloxidschicht auf der zweiten aktiven Seite der Zelle zur Herstellung eines Kontaktes, der die Metalloxidschicht auf der zweiten aktiven Seite umfasst, und dadurch, dass das Metall der Metalloxidschicht mindestens ein Element aus Mn, Ni, Mo, Cd, Sn, In, Zn, Pb, Ag, Cu, W, Ta, Ga, Fe, Co, Cr und Ti ist.

2. Verfahren nach Anspruch 1, **dadurch gekennzeichnet, dass** während des gemeinsamen Abscheidevorgangs:
- Elektronen in der ersten Kammer gegenüber der ersten aktiven Seite erzeugt werden, um das Abscheiden der Metallschicht zu begünstigen, und
- Löcher in der zweiten Kammer gegenüber der zweiten aktiven Seite erzeugt werden, um das Abscheiden durch Oxidation der Metalloxidschicht zu begünstigen.

3. Verfahren nach einem der vorhergehenden Ansprüche, **dadurch gekennzeichnet, dass** die erste und die zweite Kammer durch eine Ionenaustauschermembran getrennt sind, die der Elektrolysebehälter umfasst.

4. Verfahren nach einem der vorhergehenden Ansprüche, **dadurch gekennzeichnet, dass** das Abscheiden:
- der Metallschicht auf der ersten aktiven Seite und
- der Metalloxidschicht auf der zweiten aktiven Seite durch Beleuchten mindestens einer der ersten und der zweiten aktiven Seiten unterstützt wird.

5. Verfahren nach einem der vorhergehenden Ansprüche, **dadurch gekennzeichnet, dass** der Abscheidevorgang durch Anlegen einer Potentialdifferenz unterstützt wird, die geeignet ist, negative Ladungen auf der ersten aktiven Seite zu erzeugen.

6. Verfahren nach einem der vorhergehenden Ansprüche, **dadurch gekennzeichnet, dass** der Abscheidevorgang durch Anlegen einer Potentialdifferenz unterstützt wird, die geeignet ist, positive Ladungen auf der zweiten aktiven Seite zu erzeugen.

7. Verfahren nach einem der vorhergehenden Ansprüche, **dadurch gekennzeichnet, dass** die Photovoltaikzelle zweiseitig ist mit Homoübergang vom Typ n+ auf der ersten aktiven Seite und p+ auf der zweiten aktiven Seite.

8. Verfahren nach einem der vorhergehenden Ansprüche, **dadurch gekennzeichnet, dass** die Photovoltaikzelle auf der Basis von Silicium ist.

9. Verfahren nach einem der vorhergehenden Ansprüche, **dadurch gekennzeichnet, dass** die Metallschicht auf der ersten aktiven Seite auf der Basis von Nickel ist und dass der Schritt des Abscheidens eines elektrischen Kontaktes auf der ersten aktiven Seite durch das Abscheiden einer mindestens Kupfer umfassenden Schicht durch Elektrolyse auf der Metallschicht fortgesetzt wird.

10. Verfahren nach einem der vorhergehenden Ansprüche, **dadurch gekennzeichnet, dass** der Schritt des Abscheidens eines elektrischen Kontaktes auf der zweiten aktiven Seite durch das Abscheiden einer mindestens Kupfer umfassenden Schicht durch Elektrolyse auf der Metalloxidschicht fortgesetzt wird.

11. Verfahren nach einem der vorhergehenden Ansprüche, **dadurch gekennzeichnet, dass** dem Schritt des Abscheidens eines Kontaktes ein Schritt des Ätzens mindestens einer elektrisch isolierenden Schicht (SiO₂, SiNₓ) vorausgeht, die auf jeder aktiven Seite abgeschieden wird, wobei das Ätzen jede aktive Seite in einem Bereich freilegt, in dem der Abscheidevorgang durch Elektrolyse angewandt wird.

12. Bifaziale Photovoltaikzelle, die durch das Durchführen des Verfahrens nach mindestens einem der vorhergehenden Ansprüche erhalten wird, wobei die Zelle zwei entgegengesetzte aktive Seiten umfasst und auf jeder aktiven Seite mindestens einen elektrischen Kontakt, **dadurch gekennzeichnet, dass** der Kontakt einer ersten aktiven Seite eine Metallschicht umfasst, die auf der ersten aktiven Seite abgeschieden ist, und dass der Kontakt der zweiten aktiven Seite eine leitfähige Metalloxidschicht umfasst, die auf der zweiten aktiven Seite abgeschieden ist.

13. Zelle nach Anspruch 12, **dadurch gekennzeichnet, dass** sie einen Homoübergang vom Typ n+ auf der ersten aktiven Seite und p+ auf der zweiten aktiven Seite umfasst.

## Claims

1. A method for fabrication of a double-sided photovoltaic cell, with two opposite active surfaces, comprising a step of depositing, on each active surface, at least one electric contact, **characterized in** the step of depositing comprises a shared operation of depositing on each of the active surfaces, implemented by electrolysis in a shared electrolysis tank comprising:
- a first compartment for depositing a metal layer on a first active surface of the cell, for fabrication of a contact comprising said metal layer on the first active surface; and
- a second compartment for depositing, by oxidation, a metal oxide conductor layer on the second active surface of the cell, for the fabrication of a contact comprising said metal oxide layer on the second active surface,
And **in that** the metal in the metal oxide layer is at least one element among Mn, Ni, Mo, Cd, Sn, In, Zn, Pb, Ag, Cu, W, Ta, Ga, Fe, Co, Cr and Ti.

2. The method according to claim 1, **characterized in that**, during the shared deposition operation:
- electrons are generated in the first compartment, opposite the first active surface, for enhancing the deposit of the metal layer; and
- holes are generated in the second compartment, opposite the second active surface, for enhancing the deposit by oxidation of the metal oxide layer.

3. The method according to any one of the preceding claims, **characterized in that** the first and second compartments are separated by an ion exchange membrane that the electrolysis tank comprises.

4. The method according to any one of the preceding claims, **characterized in that**, the deposition:
- of the metal layer on the first active surface; and
- of the metal oxide layer on the second active surface,
is assisted by lighting of at least one of the first and second active surfaces.

5. The method according to any one of the preceding claims, **characterized in that** the depositing operation is assisted by application of a potential difference specific for generating at least negative charges on the first active surface.

6. The method according to any one of the preceding claims, **characterized in that** the depositing operation is assisted by application of a potential difference specific for generating positive charges on the second active surface.

7. The method according to any one of the preceding claims, **characterized in that** the photovoltaic cell is a double-sided homojunction with n⁺ type on the first active surface and p⁺ on the second active surface.

8. The method according to any one of the preceding claims, **characterized in that** the photovoltaic cell is silicon-based.

9. The method according to any one of the preceding claims, **characterized in that** the metal layer on the first active surface is nickel-based, and **in that** the step of depositing the electric contact on the first active surface is continued by depositing a layer comprising at least copper onto the metal layer, by electrolysis.

10. The method according to any one of the preceding claims, **characterized in that** the step of depositing the electric contact on the second active surface is continued by depositing a layer comprising at least copper onto the metal oxide layer, by electrolysis.

11. The method according to any one of the preceding claims, **characterized in that** the contact depositing step is preceded by a step of etching at least one electrically insulating layer (SiO₂, SiNₓ), deposited on each active surface said etching exposes each active surface in a region in which the operation of depositing by electrolysis is applied.

12. A double-sided photovoltaic cell with two opposite active surfaces, the cell comprising at least one electric contact on each active surface, **characterized in that** the contact for a first active surface comprises a metal layer deposited on the first active surface whereas the contact for the second active surface comprises a metal oxide conducting layer deposited on the second active surface.

13. The cell according to claim 12, **characterized in that** it comprises a homojunction with n⁺ type on the first active surface and p⁺ on the second active surface.
